(19) Europäisches Patentamt
European Patent Office
Office européen des brevets

(11) **EP 4 708 708 A2**

(12) **EUROPEAN PATENT APPLICATION**

(43) Date of publication:
**11.03.2026   Bulletin 2026/11**

(21) Application number: **25208865.3**

(22) Date of filing: **27.09.2019**

(51) International Patent Classification (IPC):
***H04B 1/40*** *(2015.01)*

(52) Cooperative Patent Classification (CPC):
**H04L 25/0272; H04B 1/40;** H03L 7/183;
H04L 25/00; Y02D 30/70

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(62) Document number(s) of the earlier application(s) in
accordance with Art. 76 EPC:
**19947240.8 / 4 027 535**

(71) Applicant: **Huawei Technologies Co., Ltd.
Shenzhen, Guangdong 518129 (CN)**

(72) Inventor: **GAO, Peng
Shenzhen, 518129 (CN)**

(74) Representative: **Epping - Hermann - Fischer
Patentanwaltsgesellschaft mbH
Schloßschmidstraße 5
80639 München (DE)**

Remarks:
•This application was filed on 15-10-2025 as a
divisional application to the application mentioned
under INID code 62.
•Claims filed after the date of filing of the application /
after the date of receipt of the divisional application
(Rule 68(4) EPC)

(54) **WIRELESS TRANSCEIVER APPARATUS INTEGRATED WITH COMMON CLOCK PHASE-LOCKED LOOP**

(57)     Embodiments of this application disclose a wireless transceiver apparatus. The apparatus includes a radio frequency receiver, a radio frequency transmitter, a first serializer/deserializer, and a common clock phase-locked loop. The radio frequency receiver, the radio frequency transmitter, the first serializer/deserializer, and the common clock phase-locked loop are integrated in a radio frequency chip. The radio frequency receiver includes a down converter and an analog to digital converter. The radio frequency transmitter includes an up converter and a digital to analog converter. The first serializer/deserializer is configured to provide a serial digital interface with a baseband chip for the radio frequency chip. Coupled to the analog to digital converter, the digital to analog converter, and the first serializer/deserializer separately, the common clock phase-locked loop is configured to provide a clock signal for the analog to digital converter, the digital to analog converter, and the first serializer/deserializer. The wireless transceiver apparatus can reduce an area and/or power consumption of a chip.

FIG. 4

## Description

## TECHNICAL FIELD

The present invention relates to the field of communications technologies, and in particular, to a wireless transceiver apparatus.

## BACKGROUND

In a wireless communications device, signal processing circuits may be classified into a baseband (baseband, BB) signal processing circuit and a radio frequency (radio frequency, RF) signal processing circuit. Baseband signals and radio frequency signals have different frequency ranges and different signal characteristics. Therefore, the baseband signal processing circuit and the radio frequency signal processing circuit are often separately designed and manufactured. Because an integrated circuit (integrated circuit, IC) technology has become a mainstream circuit design and manufacturing process, the baseband signal processing circuit may also be referred to as a baseband integrated circuit (baseband integrated circuit, BBIC) or a baseband chip, and the radio frequency signal processing circuit may also be referred to as a radio frequency integrated circuit (radio frequency integrated circuit, RFIC) or a radio frequency chip.

In an example of a mobile phone, a radio frequency chip and a baseband chip are usually two independently packaged chips in the mobile phone. An interface between the two chips is usually an analog interface. To be specific, communication between the chips is implemented through transmission of analog signals. An analog to digital converter (analog to digital converter, ADC) and a digital to analog converter (digital to analog converter, DAC) are built in the baseband chip. Specifically, in a receiving direction, an analog radio frequency signal is downconverted into an analog baseband signal in the radio frequency chip, then the analog baseband signal is transmitted to the baseband chip, and analog-to-digital conversion, digital demodulation, and digital decoding are performed on the analog baseband signal in the baseband chip. In a transmitting direction, digital encoding, digital modulation, and digital-to-analog conversion are performed on a digital baseband signal in the baseband chip to obtain an analog baseband signal, and the analog baseband signal is transmitted to the radio frequency chip and then up-converted into an analog radio frequency signal in the radio frequency chip.

With evolution of wireless communications technologies and gradual commercial use of technologies such as multiple input multiple output (multiple input multiple output, MIMO) and carrier aggregation (carrier aggregation, CA), growing quantities of receive paths and transmit paths need to be integrated into a wireless communications device, resulting in a large quantity of hardware connections between a radio frequency chip and a baseband chip. Because more input and output pins need to be integrated into the chips, package design of the chips is difficult, and the chips have large areas and high operating power consumption.

## SUMMARY

In view of this, embodiments of the present invention provide a wireless transceiver apparatus to reduce an area and/or power consumption of a chip.

It should be understood that in a solution provided in the embodiments of this application, a wireless communications apparatus may be a wireless communications device, or may be some components in a wireless communications device, for example, an integrated circuit product such as a system chip or a communications chip. The wireless communications device may be a computer device that supports a wireless communications function.

Specifically, the wireless communications device may be a terminal such as a smartphone, or may be a radio access network device such as a base station. A baseband chip sometimes is also referred to as a modem (modem) or baseband processing chip. A radio frequency chip sometimes is also referred to as a radio frequency transceiver (transceiver) or a radio frequency processing chip. In physical implementation, a chip may be a chip with a separate package, or a package or module in which a die (die) with input and output pins and another die or device are combined and packaged.

The wireless transceiver apparatus uses a digital interface architecture. In comparison with a conventional analog interface architecture, an analog to digital converter, a digital to analog converter, and a serializer/-deserializer are integrated in a radio frequency chip of the wireless transceiver apparatus. Therefore, communication between the radio frequency chip and a baseband chip can be implemented through serial digital signals. This reduces a large quantity of hardware connections caused by conventional multi-path parallel analog signals, thereby reducing package areas of the chips. In addition, because the analog to digital converter, the digital to analog converter, and the serializer/deserializer need respective clock signals, a common clock phase-locked loop is further integrated in the wireless transceiver apparatus, so that the areas of the chips can be further reduced and power consumption of the chips can be reduced.

According to a first aspect, an embodiment of the present invention provides a wireless transceiver apparatus, including:
a radio frequency receiver, a radio frequency transmitter, a first serializer/deserializer, and a common clock phase-locked loop.

The radio frequency receiver, the radio frequency transmitter, the first serializer/deserializer, and the common clock phase-locked loop are integrated in a radio frequency chip. The radio frequency receiver includes a down converter and an analog to digital converter. The radio frequency transmitter includes an up converter and a digital to analog converter. The first serializer/deserializer is configured to provide a serial digital interface with a baseband chip for the radio frequency chip.

Coupled to the analog to digital converter, the digital to analog converter, and the first serializer/deserializer separately, the common clock phase-locked loop is configured to provide a common clock signal for the analog to digital converter, the digital to analog converter, and the first serializer/deserializer.

Because the analog to digital converter, the digital to analog converter, and the serializer/deserializer need respective clock signals, the common clock phase-locked loop is further integrated in the wireless transceiver apparatus, so that areas of the chips can be further reduced and power consumption of the chips can be reduced.

With reference to any one of the foregoing possible implementations, in a possible implementation, the wireless transceiver apparatus further includes the baseband chip. The baseband chip includes a second serializer/deserializer. The second serializer/deserializer is configured to provide a digital interface with the radio frequency chip for the baseband chip. In this way, communication between the radio frequency chip and the baseband chip can be implemented through serial digital signals. This reduces a large quantity of hardware connections caused by conventional multi-path parallel analog signals, thereby reducing the areas of the chips.

With reference to any one of the foregoing possible implementations, in a possible implementation, an operating frequency of the serial digital interface between the first serializer/deserializer and the second serializer/deserializer uses a customized digital interface protocol. A rate of a digital signal that a driver drives to be transmitted over a differential signal line may be greater than 5824 Mbit/s or less than 1248 Mbit/s. After the customized digital interface protocol is used, the rate of the digital signal that the driver drives to be transmitted over the differential signal line can be flexibly set, thereby reducing a limitation on selecting a frequency of the clock phase-locked loop. Based on the customized interface protocol, a serial data rate is no longer limited by a standard interface protocol, but can be flexibly determined based on specific requirements of a system. Using the customized digital interface protocol makes selection of a clock rate of the serializer/deserializer (SerDes) less constrained and more flexible, thereby facilitating reuse of the common clock signal with the DAC and the ADC and reducing difficulty in and challenge to design of the common clock phase-locked loop.

With reference to any one of the foregoing possible implementations, in a possible implementation, the common clock phase-locked loop includes a common phase-locked loop and a clock generator. The common phase-locked loop is configured to generate the common clock signal. The clock generator is configured to convert the common clock signal into a plurality of parallel clock signals and output the plurality of parallel clock signals to the analog to digital converter, the digital to analog converter, and the first serializer/deserializer.

In an optional implementation, the clock generator may include a plurality of parallel inverters, configured to perform multiple-output conversion on the input common clock signal, to output a plurality of clock signals CLK_ADC, CLK_DAC, and CLK_SDS to be output to modules such as the ADC, the DAC, and the SerDes in the RFIC. The clock signals are isolated by the inverters, so that impact of a clock jitter of each module on the common clock phase-locked loop and mutual interference are reduced, and stability of the clock signals is improved.

In an optional implementation, the clock generator may include a clock frequency divider. The clock frequency divider is configured to perform frequency division on the common clock signal to generate a frequency-divided clock signal, and output the frequency-divided clock signal to the analog to digital converter, the digital to analog converter, or the first serializer/deserializer. In this way, the clock signals needed by the modules are isolated, which is equivalent to the effect of the inverters, and flexibility of the output clock signals is further implemented, so that frequencies of the clock signals can be different. In an optional implementation, the clock frequency divider may be designed to be adjustable. The clock frequency divider includes a first frequency divider, a second frequency divider, and a frequency divider selector. Frequency division ratios of the first frequency divider and the second frequency divider are different. The frequency divider selector is configured to select the first frequency divider or the second frequency divider to perform frequency division on the common clock signal. This further improves flexibility of an output frequency of a clock chip.

In an optional implementation, the common phase-locked loop may include a first sub phase-locked loop, a second sub phase-locked loop, and a phase-locked loop selector. The phase-locked loop selector is configured to select the first sub phase-locked loop or the second sub phase-locked loop to generate the common clock signal. The selection by the phase-locked loop selector can increase a speed for fast frequency switching of the common phase-locked loop and a frequency range covered by the common phase-locked loop.

With reference to any one of the foregoing possible implementations, in a possible implementation, the radio frequency receiver includes a plurality of radio frequency receive paths, and the radio frequency transmitter includes a plurality of radio frequency transmit paths. Each of the radio frequency receive paths includes one analog to digital converter, and each of the radio frequency transmit paths includes one digital to analog converter.

The radio frequency transmit paths, the radio frequency receive paths, SerDes TLs, and SerDes RLs each may include a corresponding local frequency divider. For example, each of the radio frequency receive paths may include a local analog to digital divider. The local analog to digital divider on the radio frequency receive path performs frequency division on the signal output by the common clock phase-locked loop to obtain a frequency-divided signal for provision to the analog to digital converter on the radio frequency receive path. After the local analog to digital dividers (DIVADC) are introduced to the plurality of radio frequency receive paths, the ADC on each radio frequency receive path can be provided with a respective required clock signal, so that the radio frequency receive paths can work in different bandwidth modes. This increases flexibility of receiving a plurality of signals by the radio frequency receiver. Each of the radio frequency transmit paths may further include a local digital to analog divider. The local digital to analog divider on the radio frequency transmit path performs frequency division on the signal output by the common clock phase-locked loop to obtain a frequency-divided signal for provision to the digital to analog converter on the radio frequency transmit path. After the local digital to analog dividers are introduced to the plurality of radio frequency transmit paths, the DAC on each radio frequency transmit path can be provided with a respective required clock signal, so that the radio frequency transmit paths can work in different bandwidth modes. This increases flexibility of transmitting a plurality of signals. The SerDes TLs and RLs each may include a local frequency divider. The local frequency divider performs frequency division on the signal output by the common clock phase-locked loop to obtain a clock signal needed by the lane. This increases flexibility of the clock signals needed by the TLs and RLs, so that the lanes can work in different bandwidth modes.

The plurality of radio frequency receive paths may include a first radio frequency receive path, a second radio frequency receive path, a third radio frequency receive path, and a fourth radio frequency receive path. The first radio frequency receive path is configured to receive a first carrier signal, the second radio frequency receive path is configured to receive a second carrier signal, the third radio frequency receive path is configured to receive a third carrier signal, and the fourth radio frequency receive path is configured to receive a fourth carrier signal. The plurality of radio frequency transmit paths may include a first radio frequency transmit path and a second radio frequency transmit path. The first radio frequency transmit path is configured to transmit a fifth carrier signal, and the second radio frequency transmit path is configured to transmit a sixth carrier signal. The first carrier signal, the second carrier signal, the third carrier signal, and the fourth carrier signal jointly form inter-band downlink carrier aggregation. The fifth carrier signal and the sixth carrier signal jointly form intra-band non-contiguous uplink carrier aggregation or inter-band uplink carrier aggregation. The first carrier signal and the first carrier signal may be two non-contiguous carriers in a same frequency band A, the third carrier signal may be a carrier in a frequency band B, and the fourth carrier signal may be a carrier in a frequency band C. Alternatively, the first carrier signal and the first carrier signal may be two non-contiguous carriers in the frequency band A, and the third carrier signal and the fourth carrier signal may be two non-contiguous carriers in the frequency band B. Further, the plurality of radio frequency receive paths may further include a fifth radio frequency receive path, a sixth radio frequency receive path, and a seventh radio frequency receive path. The fifth radio frequency receive path is configured to implement receiving processing on a seventh carrier signal, the sixth radio frequency receive path is configured to implement receiving processing on an eighth carrier signal, and the seventh radio frequency receive path is configured to implement receiving processing on a ninth carrier signal. The seventh carrier signal, the eighth carrier signal, and the ninth carrier signal have same frequency band characteristics as the first carrier signal. In addition, the seventh carrier signal, the eighth carrier signal, and the ninth carrier signal are received from an antenna different from that for a first radio frequency signal. In this way, a seventh radio frequency signal, an eighth radio frequency signal, a ninth radio frequency signal, and the first radio frequency signal form receiving of a 4x4 MIMO signal. Therefore, the radio frequency chip implements CA and MIMO features.

With reference to any one of the foregoing possible implementations, in a possible implementation, the radio frequency receive path may include an in-phase receive branch and a quadrature receive branch. The in-phase receive branch and the quadrature receive branch each include one analog to digital converter. The local analog to digital divider on the radio frequency receive path is configured to provide a same clock signal for an analog to digital converter in the in-phase receive branch and an analog to digital converter in the quadrature receive branch on the radio frequency receive path.

The radio frequency transmit path may include an in-phase transmit branch and a quadrature transmit branch. The in-phase transmit branch and the quadrature transmit branch each include one digital to analog converter. The local digital to analog divider on the radio frequency transmit path is configured to provide a same clock signal for a digital to analog converter in the in-phase transmit branch and a digital to analog converter in the quadrature transmit branch on the radio frequency transmit path.

In this way, one radio frequency receive path or transmit path needs only one local frequency divider to provide a clock signal for both ADCs or DACs on I and Q branches of the radio frequency receive path or transmit path. This further saves frequency divider resources, and ensures that the ADCs or DACs on the I and Q branches have the same clock signal and that the I and Q signals have same bandwidth processing.

With reference to any one of the foregoing possible implementations, in a possible implementation, frequency division ratios of the clock frequency divider, the local analog to digital dividers, the local analog to digital dividers, and the local frequency dividers in the SerDes TLs and RLs each may be a positive integer or a sum of a positive integer and a simple decimal, where the simple decimal is a negative integer power of 2. Based on the foregoing frequency division ratios, implementation cost factors such as circuit implementation complexity, power consumption, and an area are reduced.

With reference to any one of the foregoing possible implementations, in a possible implementation, the wireless transceiver apparatus further includes: a radio frequency front-end module. The radio frequency front-end module includes a low noise amplifier. The radio frequency front-end module is located between the radio frequency chip and an antenna. The radio frequency chip further includes a p-channel metal oxide semiconductor PMOS transistor and an n-channel metal oxide semiconductor NMOS transistor. A source of the PMOS transistor is configured to be coupled to a power supply end, and a source of the NMOS transistor is configured to be coupled to a ground end. Drains of the PMOS transistor and the NMOS transistor are coupled as an output end, which is configured to be coupled to the down converter. Gates of the PMOS transistor and the NMOS transistor are coupled as an input end, which is configured to be coupled to the low noise amplifier. The PMOS transistor and the NMOS transistor are configured to implement a transition between the LNA outside the radio frequency chip and a mixer inside the radio frequency chip. On the basis of signal amplification by the low noise amplifier of the radio frequency front-end module, a gain of a radio frequency signal of the system can be further increased, and flexibility of power control of the system can be improved.

When the RF FEM is integrated with a PA, the transmitter in the radio frequency chip may also be integrated with a transmit amplifier (TX_AMP) before the mixer to implement a transition between the mixer and the off-chip PA. On the basis of the PA of the off-chip RF FEM, a receive amplifier (RX_AMP) and the transmit amplifier (TX_AMP) can further adjust the gain of the radio frequency signal of the system and improve the flexibility of the power control of the system.

With reference to any one of the foregoing possible implementations, in a possible implementation, the radio frequency chip may further include a local oscillator phase-locked loop, configured to provide local oscillator signals needed for frequency conversion for the up converter and/or the down converter. In consideration of a great difference in requirements and performance between the common clock phase-locked loop providing the clock signals for the ADC, the DAC, and the SerDes and the phase-locked loop providing local oscillator signals for radio frequency transmit and receive paths, using the local oscillator phase-locked loop to separately provide the local oscillator signals for the radio frequency transmit and receive paths improves efficiency and performance of clock signal design of the system from a perspective of system design.

Further, the local oscillator phase-locked loop may further include a first local oscillator phase-locked loop (LO_PLL1) and a second local oscillator phase-locked loop (LO_PLL2). The first local oscillator phase-locked loop is configured to provide a local oscillator signal for the down converter on the radio frequency receive path, and the second local oscillator phase-locked loop is configured to provide a local oscillator signal for the up converter on the radio frequency transmit path. Still further, the first local oscillator phase-locked loop and the second local oscillator phase-locked loop are configured to provide local oscillator signals for mixers on the radio frequency receive path and the radio frequency transmit path. Different requirements of the radio frequency transmit and receive paths for the phase-locked loops are met, and performance of the radio frequency chip can be further optimized.

Further, reference signals of the common clock phase-locked loop, the first local oscillator phase-locked loop, and the second local oscillator phase-locked loop may be provided by a same reference clock signal CLK_REF. The reference signal CLK_REF may be input from the outside of the radio frequency chip through a same pin of the radio frequency chip. Therefore, an internal control timing of the chip can be synchronized with received and transmitted signals.

With reference to any one of the foregoing possible implementations, in a possible implementation, the wireless transceiver apparatus further includes a power supply chip. The power supply chip is coupled to the radio frequency chip. The power supply chip supplies power to the radio frequency chip and provides a reference clock signal for the common clock phase-locked loop. In this way, the clock reference signal provided by the power supply chip can cooperate with timings of the power supply chip and the radio frequency chip to synchronize power-on and power-off of an entire chipset and optimize functions of the wireless transceiver apparatus. The power supply chip may also be referred to as a power management chip.

**BRIEF DESCRIPTION OF DRAWINGS**

FIG. 1 is a schematic diagram of a structure of a wireless communications system according to an embodiment of this application;
FIG. 2 is a schematic diagram of a configuration of a carrier of a wireless communications system according to an embodiment of this application;
FIG. 3 is a schematic diagram of a deployment example of downlink inter-band carrier aggregation according to an embodiment of this application;

FIG. 4 is a schematic diagram of a wireless transceiver apparatus according to an embodiment of this application;

FIG. 5A is a schematic diagram of a structure of a SerDes according to an embodiment of this application;

FIG. 5B is a schematic diagram of transmitting and receiving signals through a SerDes interface according to an embodiment of this application;

FIG. 6 is a schematic diagram of a common clock phase-locked loop according to an embodiment of this application;

FIG. 7 is a schematic diagram of another wireless transceiver apparatus according to an embodiment of this application;

FIG. 8 is a schematic diagram of an architecture of a receiver according to an embodiment of this application;

FIG. 9 is a schematic diagram of a local frequency divider based on an orthogonal architecture according to an embodiment of this application;

FIG. 10 is a schematic diagram of a radio frequency receiver and a radio frequency transmitter according to an embodiment of this application;

FIG. 11 is a schematic diagram of a radio frequency chip according to an embodiment of this application; and

FIG. 12 is a schematic diagram of a phase-locked loop according to an embodiment of this application.

## DESCRIPTION OF EMBODIMENTS

The following describes the technical solutions in the embodiments of the present invention in detail with reference to the accompanying drawings. It is clear that the described embodiments are a part rather than all of the embodiments of the present invention. All other embodiments obtained by a person of ordinary skill in the art based on the embodiments of the present invention without creative efforts shall fall within the protection scope of the present invention.

In a wireless communications system, devices may be classified into devices that provide a wireless network service and devices that use the wireless network service. The devices that provide a wireless network service are devices that form a wireless communications network, and may be briefly referred to as network devices (network device) or network elements (network element). The network devices usually belong to operators (for example, China Mobile and Vodafone) or infrastructure providers (for example, China Tower), and are operated or maintained by these vendors. The network devices may further be classified into a radio access network (radio access network, RAN) device and a core network (core network, CN) device. The RAN device typically includes a base station (base station, BS).

It should be understood that the base station may also sometimes be referred to as a wireless access point (access point, AP) or a transmission reception point (transmission reception point, TRP). Specifically, the base station may be a universal NodeB (next generation NodeB, gNB) in a 5G new radio (new radio, NR) system or an evolved NodeB (evolved NodeB, eNB) in a 4G long term evolution (long term evolution, LTE) system. Base stations may be classified into a macro base station (macro base station) or a micro base station (micro base station) based on different physical forms or transmit power of the base stations. The micro base station is also sometimes referred to as a small base station or a small cell (small cell).

The devices that use the wireless network service are usually located on an edge of a network, and may be briefly referred to as terminals (terminal). The terminal can establish a connection to the network device, and provide a specific wireless communications service for a user based on a service of the network device. It should be understood that, because the terminal has a closer relationship with the user, the terminal is also sometimes referred to as user equipment (user equipment, UE) or a subscriber unit (subscriber unit, SU). In addition, compared with the base station that is usually placed at a fixed location, the terminal usually moves along with the user, and is also sometimes referred to as a mobile station (mobile station, MS). In addition, some network devices such as a relay node (relay node, RN) or a wireless router may also sometimes be considered as terminals because the network devices have a UE identity or belong to the user.

Specifically, the terminal may include a mobile phone (mobile phone), a tablet computer (tablet computer), a laptop computer (laptop computer), a wearable device (for example, a smartwatch, a smart band, a smart helmet, or smart glasses), other devices that have a wireless access capability, for example, an intelligent vehicle, various internet of things (internet of things, IoT) devices including various smart home devices (such as a smart meter and a smart home appliance) and smart city devices (such as a security or monitoring device and an intelligent transportation facility), and the like.

For ease of description, the technical solutions in the embodiments of this application are described in detail by using a base station and a terminal as an example in this application.

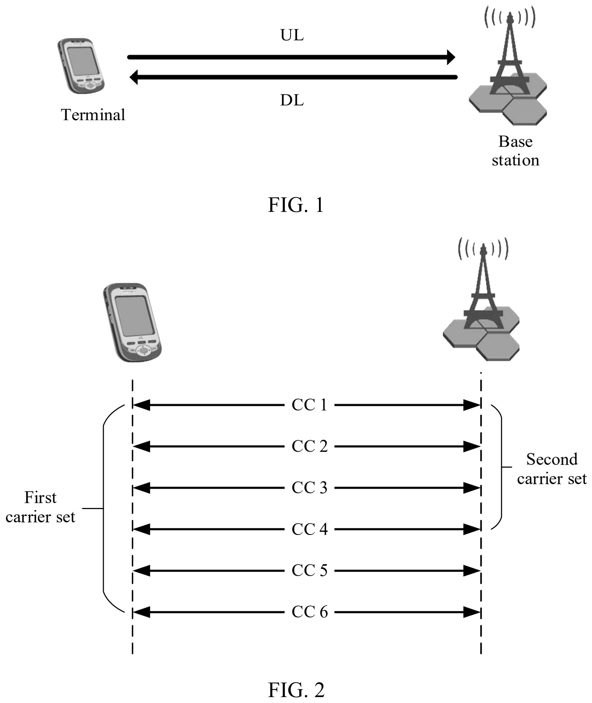

FIG. 1 is a schematic diagram of a structure of a wireless communications system according to an embodiment of this application. As shown in FIG. 1, the wireless communications system includes a terminal and a base station. Based on different transmission directions, a transmission link from the terminal to the base station is referred to as an uplink (uplink, UL), and a transmission link from the base station to the terminal is referred to as a downlink (downlink, DL). Similarly, data transmission over the uplink may be briefly referred to as uplink data transmission or uplink transmission, and data transmission over the downlink may be briefly referred to as downlink data transmission or downlink transmission.

In the wireless communications system, the base station may provide communications coverage for a specific geographical area by using an integrated or external antenna device. One or more terminals in the communications coverage of the base station may be connected to the base station. One base station may manage one or more cells (cell). Each cell has one identification (identification). The identity is also referred to as a cell identifier (cell identifier, cell ID). From a perspective of a radio resource, a cell is a combination of a downlink radio resource and an uplink radio resource (optional) that is paired with the downlink radio resource.

It should be understood that the wireless communications system may comply with a wireless communications standard in the 3rd generation partnership project (3rd generation partnership project, 3GPP), or may comply with another wireless communications standard, for example, a wireless communications standard in the 802 series (for example, 802.11, 802.15, or 802.20) of the Institute of Electrical and Electronics Engineers (Institute of Electrical and Electronics Engineers, IEEE). Although FIG. 1 shows only one base station and one terminal, the wireless communications system may alternatively include other quantities of terminals and base stations. In addition, the wireless communications system may further include another network device, for example, a core network device.

The terminal and the base station should know configurations predefined by the wireless communications system, including a radio access technology (radio access technology, RAT) supported by the system and a configuration of a radio resource stipulated by the system, for example, a radio frequency band and a basic configuration of a carrier. The carrier is a frequency range that complies with a stipulation of the system. The frequency range may be determined jointly based on a center frequency of the carrier (denoted as a carrier frequency) and bandwidth of the carrier. The configurations predefined by the system may be used as a part of a standard protocol for the wireless communications system, or may be determined through interaction between the terminal and the base station. Content of a related standard protocol may be prestored in memories of the terminal and the base station, or reflected as hardware circuits or software code of the terminal and the base station.

In the wireless communications system, the terminal and the base station each support one or more same RATs, for example, 5G NR, 4G LTE, or a RAT for a future evolved system. Specifically, the terminal and the base station each use a same air interface parameter, a same coding scheme, a same modulation scheme, and the like, and communicate with each other based on the radio resource stipulated by the system.

FIG. 2 is a schematic diagram of a carrier configuration of a wireless communications system according to an embodiment of this application. In the wireless communications system, a base station configures two carrier sets for a terminal, and the two carrier sets are respectively denoted as a first carrier set and a second carrier set. The first carrier set may be used for downlink carrier aggregation, and the second carrier set may be used for uplink carrier aggregation. Carriers included in the two carrier sets may be partially the same, or may be all the same.

As shown in FIG. 2, the first carrier set includes six component carriers (component carriers, CCs): CC1 to CC6. The second carrier set includes four component carriers: CC1 to CC4 It should be understood that quantities of CCs included in the first carrier set and the second carrier set are merely an example. In this embodiment of this application, the first carrier set and the second carrier set may alternatively include other quantities of CCs. The CCs may be consecutive or non-consecutive in frequency domain. Different CCs may be in a same frequency band, and may correspond to intra-band carrier aggregation (intra-band CA). Alternatively, different CCs may be in different frequency bands, and may correspond to inter-band carrier aggregation (inter-band CA).

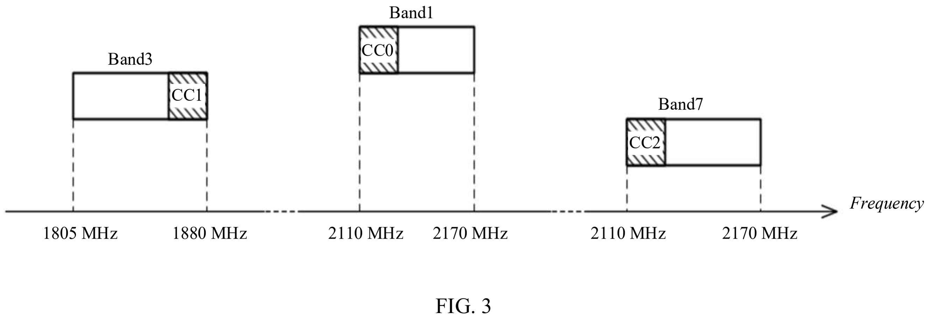

FIG. 3 is a schematic diagram of a deployment example of inter-band downlink carrier aggregation (Downlink inter-band CA, DLCA) according to an embodiment of this application. As shown in the figure, a system allocates component carriers CC0, CC1, and CC2 to a terminal in three frequency bands: Band1 (2110 MHz to 2170 MHz), Band3 (1805 MHz to 1880 MHz), and Band7 (2110 MHz to 2170 MHz). Assuming that bandwidths of the three component carriers each are 20 MHz, a user of the terminal can obtain a total of 60 MHz of spectrum resources through the foregoing deployment of the inter-band carrier aggregation.

To support a receiving application of the foregoing inter-band carrier aggregation, the terminal needs to have a capability of simultaneously receiving a plurality of component carriers. Because the plurality of component carriers are separately located in different frequency bands, limited by frequency bandwidth characteristics of the radio frequency front-end module and the radio frequency receiver circuit, generally, a plurality of radio frequency receive paths that work in parallel are required for receiving each component carrier. The carrier aggregation scenario of three frequency bands shown in FIG. 3 is used as an example. Three radio frequency receive paths need to work simultaneously to receive three component carriers. For a carrier aggregation scenario of more frequency bands, a quantity of paths of the radio frequency receiver needs to be increased accordingly. Similarly, to support a transmission application of inter-band carrier aggregation, a radio frequency chip also needs to have a plurality of radio frequency transmit paths working simultaneously to transmit a plurality of component carriers, to have a capability of simultaneously transmitting a plurality of component carriers.

Another development trend of wireless communication is to use a multi-antenna technology to improve communication performance, that is, use a MIMO technology to perform wireless transmission by using a plurality of antennas at the same time, to improve a throughput rate of wireless communication. A wireless terminal device that supports the MIMO technology needs to provide a plurality of antennas, and a radio frequency receiver and a radio frequency transmit path that are corresponding to a quantity of the antennas. For example, for a downlink 4x4 MIMO application scenario, at a mobile terminal side, even if there is only one component carrier, four receive antennas and radio frequency receive paths corresponding to the antennas may be required.

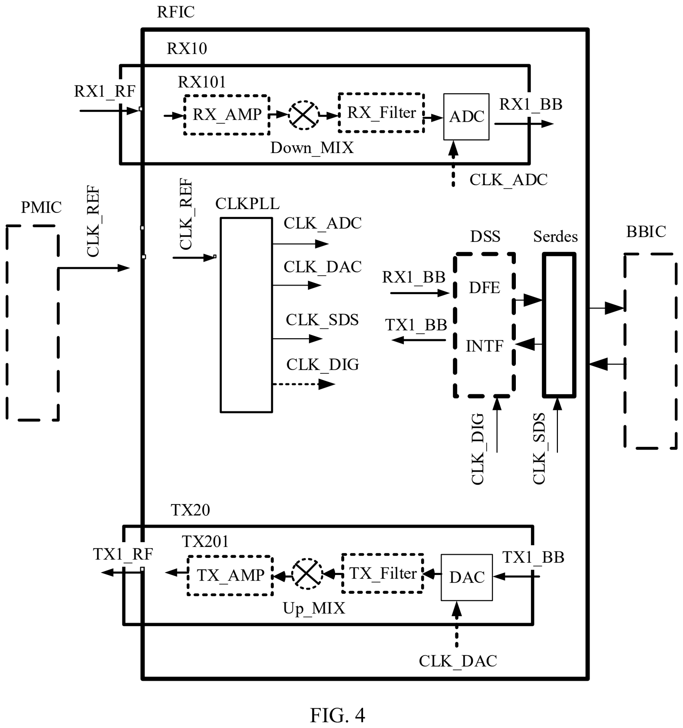

FIG. 4 is a schematic diagram of a wireless transceiver apparatus according to an embodiment of this application. It should be understood that although the wireless transceiver apparatus in FIG. 4 shows only one radio frequency receive path and one radio frequency transmit path, the wireless transceiver apparatus in embodiments of this application is not limited thereto. The wireless transceiver apparatus may further include two or more radio frequency receive paths and radio frequency transmit paths.

Refer to FIG. 4. The wireless transceiver apparatus includes a radio frequency chip. The radio frequency chip includes a radio frequency receiver (RX 10), a radio frequency transmitter (TX 20), a common clock phase-locked loop (CLKPLL), and a serializer/deserializer (Serializer/Deserializer, SerDes). The radio frequency receiver (RX 10) may include a radio frequency receive path (RX 101), the first radio frequency receive path (RX 101) includes a down converter (Down_MIX) and an analog to digital converter (ADC), and the down converter is configured to perform down-conversion processing on a received radio frequency signal. The analog to digital converter is configured to convert, into a digital signal, a signal obtained through down-conversion processing.

The radio frequency receive path may further include a receive filter (RX_Filter). The receive filter is located between the down converter and the digital to analog converter. The receive filter performs filtering on the signal obtained through down-conversion processing by the down converter, and then provides the filtered signal to the analog to digital converter, to suppress an interference signal outside the receive path, and improve signal sensitivity of the receive path.

The radio frequency transmitter further includes a radio frequency transmit path (TX 201). The radio frequency transmit path includes a digital to analog converter (DAC) and a transmit mixer (TX _MIX). The DAC is configured to convert a received digital signal into an analog signal. The transmit mixer performs up-conversion processing on the analog signal converted by the DAC, and transmits the analog signal.

The radio frequency transmit path may further include a transmit filter (TX _Filter). The transmit filter is located between the transmit mixer and the digital to analog converter. After filtering an analog signal converted by the digital to analog converter, the transmit filter provides the analog signal to the transmit mixer for up-conversion processing, to suppress out-of-band harmonics of the transmit path.

The transmit filter and the receive filter may have a gain amplification function, and may perform gain amplification on a signal when filtering the signal. Gains of the transmit filter and the receive filter may alternatively be designed to be adjustable, to implement flexible configuration of signal gains.

The serializer/deserializer (SerDes) is configured to implement digital interface communication between the radio frequency chip and an external baseband chip. Because the SerDes is used, the radio frequency chip can implement a higher transmission rate with a same quantity of chip pins (Pin), to reduce an area of the radio frequency chip.

The common clock phase-locked loop provides a corresponding clock signal for the ADC, the DAC, and the serializer/deserializer (SerDes) interface. The common clock phase-locked loop provides a clock signal CLK_ADC for the ADC, a CLK_DAC for the DAC, and a CLK_SDS for the SerDes. A quantity of phase-locked loops inside the radio frequency chip can be reduced by sharing the clock phase-locked loop, to further reduce the area and power consumption of the radio frequency chip. In addition, because the quantity of clock phase-locked loops is reduced, mutual interference caused by clock signals inside the system is also greatly reduced, to further improve performance of the radio frequency chip.

Further, the wireless transceiver apparatus may further include a baseband chip. A digital interface corresponding to serializer/deserializer (SerDes) of the radio frequency chip, namely, a serializer/deserializer (SerDes) of the baseband chip, may alternatively be integrated inside the baseband chip. Pins of the serializer/deserializer (SerDes) in the baseband chip and pins of the serializer/deserializer (SerDes) in the radio frequency chip are coupled to each other in a one-to-one correspondence, to implement digital signal transmission between the radio frequency chip and the baseband chip. Because the serializer/deserializer (SerDes) is introduced, when a signal between the radio frequency chip and the baseband chip is on a same pin, a chip group communication rate can be greatly increased, and path bandwidth for processing by the wireless transceiver apparatus can be further increased.

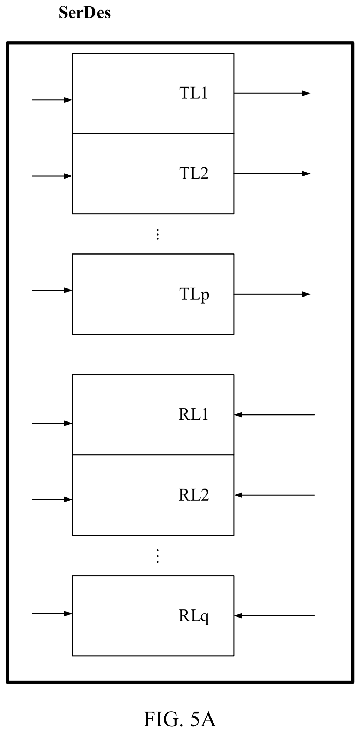

FIG. 5A is a schematic diagram of a structure of a SerDes according to an embodiment of this application. A SerDes in a radio frequency chip is used as an example. The SerDes includes a plurality of transmit lanes (TLs, transmit lanes) and receive lanes (RLs, receive lanes). The SerDes transmit lanes (TLs, transmit lanes) in the radio frequency chip serialize received parallel data and transmit serial data to the receive lanes. The receive lanes (RLs, receive lanes) receive the serial data and convert the serial data into parallel data. A working mechanism of a SerDes in a BBIC is the same as that in the radio frequency chip. A common phase-locked loop in the RFIC provides needed clock signals for each TL and RL.

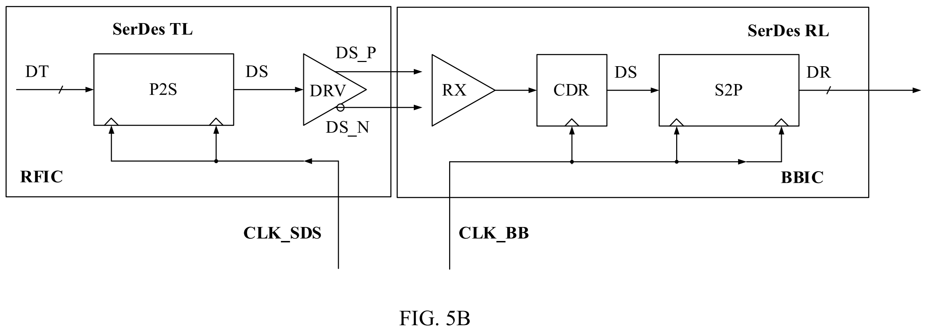

FIG. 5B is a schematic diagram of transmitting and receiving signals through a SerDes interface according to an embodiment of this application. Specifically, in a receive link direction of an RFIC, a (SerDes TL) transmit lane in the RFIC processes received parallel data through a parallel to serial converter (parallel to serial converter, P2S) to obtain serial data, and a driver (DRV, driver) drives the serial data to be transmitted over a group of differential signal lines (DS_P and DS_N) to a BBIC. A SerDes receive lane (RL, receive lane) in the BBIC receives the serial data, processes the serial data through clock data recovery (CDR, clock data recovery) and then uses a serial to parallel converter (serial to parallel converter, S2P) to obtain parallel data, and decodes and unpacks the parallel data. A working mechanism of the SerDes in a transmit link direction of the RFIC is similar to that on the receive link, except that the direction is reversed, that is, data is transmitted from the BBIC to the RFIC. A common phase-locked loop in the RFIC provides a needed clock signal CLK_SDS for the parallel to serial converter (P2S), while the BBIC provides needed clock signals CLK_BB for the CDR and the S2P.

Further, data and instruction signals transmitted between the RFIC and the BBIC over the serializer/deserializer (SerDes) interface may be transmitted by using a customized interface protocol instead of a standard interface protocol such as the MIPI M-PHY protocol, the JEDEC JESD204B protocol, or a DDR protocol. The standard interface protocol facilitates interconnection between an RFIC and a BBIC of different manufacturers. However, the standard interface protocol has specific requirements for a serial data rate of the SerDes, that is, limits a frequency of a working clock of the SerDes. When the standard interface protocol is used, a serial digital signal that the driver drives to be transmitted over the differential signal line has several fixed rates. For example, when MIPI M-PHY is used, the digital signal that the driver drives to be transmitted over the differential signal line has several specific rates from 1248 Mbit/s to 5824 Mbit/s. A clock rate for driving the SerDes is usually equal to or half the rate of the data signal. Consequently, selection of a frequency of a common clock phase-locked loop is limited. After the customized digital interface protocol is used, the rate of the digital signal that the driver drives to be transmitted over the differential signal line can be flexibly set to be greater than 5824 Mbit/s or less than 1248 Mbit/s to reduce a selection limitation on the frequency of the clock phase-locked loop. Based on the customized interface protocol, a serial data rate is no longer limited by a standard interface protocol, but can be flexibly determined based on specific requirements of a system. Using the customized digital interface protocol makes the selection of the clock rate of the serializer/deserializer (SerDes) less constrained and more flexible, thereby facilitating reuse of the clock signal with a DAC and an ADC and reducing difficulty in and challenge to design of the clock phase-locked loop.

Further, one or more radio frequency front-ends (radio frequency frontend, RF FEM) may be further included between the RFIC and an antenna. The radio frequency front-end is located between the RFIC and the antenna, and is configured to improve quality of received and transmitted signals of a wireless transceiver apparatus. When a radio frequency chip needs to be integrated with a plurality of receive paths and transmit paths, for example, for a radio frequency chip that supports carrier aggregation or MIMO, a signal-to-noise ratio and transmit power of transmitted signals of the plurality of parallel receive paths and transmit paths need to meet higher design specification requirements. Therefore, a multi-path design challenge cannot be overcome by relying only on a circuit integrated in the radio frequency chip. In consideration of costs and an area, a radio frequency front-end is not an ideal choice in a wireless transceiver apparatus, especially a chip of a mobile phone terminal. Especially for a low noise amplifier (low noise amplifier, LNA), on-chip integration is usually adopted. However, for a multi-path radio frequency chip, benefits of the radio frequency front-end outweigh disadvantages of the costs and the area.

The radio frequency front-end in this embodiment may include an integrated low noise amplifier (LNA) module. The LNA module may include an LNA circuit configured to amplify a received antenna signal to reduce signal loss on a transmission path, thereby further improving quality of the signal transmitted from the antenna to the radio frequency chip. The radio frequency front-end in this embodiment may further include an integrated power amplifier (power amplifier, PA) module. The PA module may include a PA power amplifier obtained through a process more suitable for high power, for example, a gallium arsenide (GaAs) process or a gallium nitride (GaN) process. The PA module may further include a filter and a switch, to further implement high-quality power amplification of an output signal of the radio frequency chip and reduce inter-path interference, to further improve output power and quality of the signal transmitted by the RFIC and performance of a transmit system in the present invention.

The PA module and LNA module may be integrated in different radio frequency front-ends or a same radio frequency front-end, and are flexibly designed based on specific design requirements of the system. Usually, because the PA module and LNA module implement signal transmitting and receiving functions, to improve isolation between a transmitter and a receiver, the PA module and LNA module may be separately integrated in different radio frequency front-end modules.

Further, when the LNA is integrated in an off-chip RF FEM, the receiver in the RFIC may also be integrated with a receive amplifier (RX _AMP) at a front-end of a mixer to implement a transition between the off-chip LNA and the mixer in the radio frequency chip. The RX_AMP may include a simple amplification circuit.

For example, the simple amplification circuit may include a p-channel metal oxide semiconductor (PMOS) transistor and an n-channel metal oxide semiconductor (NMOS) transistor that are connected in series. A source of the PMOS transistor is coupled to a power supply signal, and a source of the NMOS transistor is coupled to a ground (GND). Drains of the PMOS transistor and the NMOS transistor are coupled as an output end, which is configured to be coupled to a down converter. Gates of the PMOS transistor and the NMOS transistor are used as an input end, which is configured to be coupled to a radio frequency signal amplified by the off-chip LNA. Similar to the LNA, when the RF FEM is integrated with the PA, the transmitter in the radio frequency chip may also be integrated with a transmit amplifier (TX_AMP) before the mixer to implement a transition between the mixer and the off-chip PA. On the basis of the off-chip RF FEM, the receive amplifier (RX_AMP) and the transmit amplifier (TX_AMP) can further adjust a gain of a radio frequency signal of the system and improve flexibility of power control of the system.

Further, in an application scenario or system that has a low requirement on signal transmission performance, for example, a wireless hotspot (Wi-Fi) network, an internet of things (internet of things, IoT), or some low-cost mobile phone terminals that have a low requirement on communication quality, some or all LNAs or PAs may be integrated in the RFIC to reduce a quantity of radio frequency front-end modules, thereby reducing the costs and the area of the wireless transceiver apparatus and improve competitiveness of the wireless transceiver apparatus.

Further, the LNA and the PA may share one antenna to implement transceiver duplexing or frequency division duplexing.

Further, the radio frequency chip in this embodiment may further be integrated with some digital sub-systems (digital sub-systems, DSSs), for example, a digital front-end (digital front end, DFE) and an interface (interface unit, INTF). The DFE includes a receive digital front-end and a transmit processing front-end. The DFE mainly performs data sampling rate conversion, and calibration and compensation operations related to non-ideal characteristics of the RF circuit, to further improve performance of the radio frequency chip. The INTF mainly performs processing such as encoding and packaging. Data processed by the INTF is transmitted to the serializer/deserializer (SerDes), to further improve transmission reliability. The common clock phase-locked loop may also provide a clock signal CLK_DIG for the DFE and the INTF to further reduce an area and power consumption of the radio frequency chip.

Further, the clock signal of the serializer/deserializer (SerDes) in the RFIC may alternatively be from an external BBIC. Compared with the solution in which the independent serializer/deserializer (SerDes) phase-locked loop is designed in the RFIC, the clock signal solution of the serializer/deserializer (SerDes) can save clock resources to reduce the area and power consumption of the RFIC. However, in the clock signal solution of the serializer/deserializer (SerDes), because the clock signal of the serializer/deserializer (SerDes) is from the external chip, a frequency of the clock signal is limited, and a transmission rate of a signal between the RFIC and the BBIC is limited. As a result, requirements for a higher rate and more paths on transmission between the RFIC and the BBIC cannot be met.

Further, the common clock phase-locked loop in the RFIC needs a clock reference signal (clock reference signal, CLK_REF) as a reference signal to generate a clock signal to be output. A wireless communications apparatus may include a power management chip (power management integrated circuit, PMIC). In addition to powering the RFIC and BBIC, the PMIC may provide the CLK_REF for the common clock phase-locked loop. The wireless communications apparatus may alternatively include an external clock source, for example, a crystal (crystal), configured to provide the CLK_REF for the common clock phase-locked loop. An oscillator, such as a resistor-capacitor (RC) oscillator, may alternatively be integrated in the RFIC to generate the CLK_REF. In comparison with other methods for generating the clock reference signal, the clock reference signal provided by the PMIC can cooperate with timings of the power management chip and the radio frequency chip to synchronize power-on and power-off of an entire chipset and optimize functions of the chipset.

In this embodiment, the serializer/deserializer (SerDes), the DAC, and the ADC are integrated into the RFIC to implement digital interface communication between the RFIC and the BBIC and increase a rate of inter-chip communication with a same quantity of pins. In addition, in this embodiment, a same common clock phase-locked loop is used to provide clock signals for the ADC, the DAC, the serializer/deserializer (SerDes), and the like integrated in the RFIC, to implement reuse of the phase-locked loop and reduce the area and power consumption of the entire radio frequency chip.

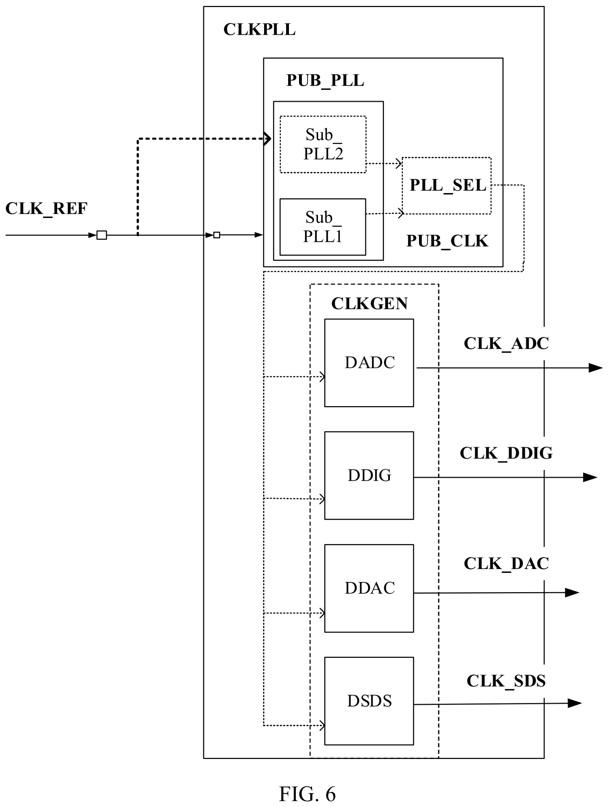

FIG. 6 is a schematic diagram of a common clock phase-locked loop according to an embodiment of this application. On the basis of the foregoing embodiments, the common clock phase-locked loop (CLKPLL) may further include a common phase-locked loop (PUB_PLL) and a clock generator (CLKGEN).

Specifically, the common phase-locked loop is configured to output a common clock signal (PUB_CLK) to the clock generator. The clock generator may perform one-to-many conversion on the common clock signal, to generate a plurality of corresponding clock signals CLK_ADC, CLK_DAC, and CLK_SDS to be output to modules such as the ADC, the DAC, and the SerDes in the RFIC.

For example, the clock generator may have a direct mode. To be specific, the same common clock signal is directly output to modules such as the ADC, the DAC, and the SerDes in the RFIC and used as the corresponding clock signals CLK_ADC, CLK_DAC, and CLK_SDS of the modules. In this case, the clock signals needed by the modules are the same.

The clock generator may include a plurality of parallel inverters, configured to perform multiple-output conversion on the input common clock signal, to output a plurality of clock signals CLK_ADC, CLK_DAC, and CLK_SDS to be output to modules such as the ADC, the DAC, and the SerDes in the RFIC. The clock signals are isolated by the inverters, so that impact of a clock jitter of each module on the common clock phase-locked loop and mutual interference are reduced, and stability of the clock signals is improved.

The clock generator CLKGEN may alternatively include a plurality of parallel clock frequency dividers. The clock generator CLKGEN performs frequency division on the input common clock signal and outputs frequency-divided clock signals CLK_ADC, CLK_DAC, and CLK_SDS needed by modules such as the ADC, the DAC, and the SerDes in the RFIC to these modules. In this way, the clock signals needed by the modules are isolated, which is equivalent to the effect of the inverters, and flexibility of the output clock signals is further implemented, so that frequencies of the clock signals can be different.

Specifically, four parallel clock frequency dividers are used as an example. The clock generator includes an ADC clock frequency divider DADC, a DAC clock frequency divider DDAC, a digital sub-system clock frequency divider DDIG, and a serializer/deserializer (SerDes) clock frequency divider DSDS. It should be understood that although FIG. 6 shows that CLKGEN includes only four parallel clock frequency dividers, the embodiments of this application are not limited thereto. CLKGEN may alternatively include another quantity of clock frequency dividers. It is assumed that a frequency of the common clock signal generated by the common phase-locked loop is $f_{CLK\_PLL}$.

DADC may generate the clock signal CLK_ADC needed by the ADC in the RFIC. Assuming that a frequency of CLK_ADC is $f_{CLK\_ADC}$ and a frequency division ratio of DADC is $N_{DADC}$, the following relationship exists:

$$f_{CLK_{ADC}} = \frac{f_{CLK_{PLL}}}{N_{DADC}}$$

DDAC may generate the clock signal CLK_DAC needed by the DAC in the RFIC. Assuming that a frequency of CLK_DAC is $f_{CLK\_DAC}$ and a frequency division ratio of the DDAC is $N_{DDAC}$, the following relationship exists:

$$f_{CLK\_DAC} = \frac{f_{CLK\_PLL}}{N_{DDAC}}$$

DDIG may generate the clock signal CLK_DIG needed by a plurality of digital sub-systems in the RFIC.

In the digital sub-systems, one-to-many conversion is further performed on the signal CLK_DIG, to provide clock signals needed by the DFE and the INTF in the digital sub-systems.

Assuming that a frequency of CLK_DAC is $f_{CLK\_DIG}$ and a frequency division ratio of DDIG is $N_{DDIG}$, the following relationship exists:

$$f_{CLK\_DIG} = \frac{f_{CLK\_PLL}}{N_{DDIG}}$$

DSDS may generate the clock signal CLK_SDS needed by the serializer/deserializer (SerDes) in the RFIC. The clock signal CLK_SDS is sent to the serializer/deserializer (SerDes) to provide a needed clock signal for each of the transmit lanes (TLs) and receive lanes (RLs) of the serializer/deserializer (SerDes). Assuming that a frequency of CLK_SDS is $f_{CLK\_SDS}$ and a frequency division ratio of DSDS is $N_{DSDS}$, the following relationship exists:

$$f_{CLK\_SDS} = \frac{f_{CLK\_PLL}}{N_{DSDS}}$$

In conclusion, the clock signals of different frequencies needed by the ADC, the DAC, the digital sub-system, the serializer/deserializer (SerDes), and the like in the digital interface RFIC are all from the same common clock signal (PUB_CLK). The clock phase-locked loop CLKPLL uses CLK_REF as a reference clock signal, and the common phase-locked loop (PUB_PLL) generates the common clock signal (PUB_CLK) whose frequency is $f_{CLK\_PLL}$. The clock signal is processed by various clock frequency dividers in the clock generator CLK_GEN to generate various needed clock signals.

In conclusion, the clock signals needed by the ADC, the DAC, the digital sub-system, the serializer/deserializer (SerDes), and the like may all be from the common clock signal (PUB_CLK).

Further, each clock frequency divider in CLKGEN may need to be designed as a variable frequency divider based on clock frequency requirements of the ADC, the DAC, the digital sub-system, the serializer/deserializer (SerDes), and the like to add a function of dynamically adjusting the frequency division ratio.

Specifically, the variable frequency divider may include a plurality of parallel frequency dividers with different frequency division ratios and a frequency divider selector. A frequency divider with a specific frequency division ratio is selected by the frequency divider selector, so that the frequency division ratio of the frequency divider is variable.

For example, the variable frequency divider may include a first frequency divider, a second frequency divider, and a frequency divider selector. Frequency division ratios of the first frequency divider and the second frequency divider are different. The first frequency divider and the second frequency divider are connected in parallel. The frequency divider selector is configured to select the first frequency divider or the second frequency divider to output a frequency-divided clock signal. In this way, the frequency division ratio of the variable frequency divider is adjustable.

The frequency divider selector may be a single-pole double-throw switch, located at inputs or outputs of the first frequency divider and the second frequency divider. The switch is switched to select the first frequency divider or the second frequency divider to perform frequency division on the common clock signal. The frequency divider selector may alternatively be two single-pole switches, located at the inputs or outputs of the first frequency divider and the second frequency divider. The switch is switched to select the first frequency divider or the second frequency divider to perform frequency division on the common clock signal. The frequency divider selector may alternatively be a power controller, configured to choose to supply power to the first frequency divider or the second frequency divider, to implement frequency division processing on the common clock signal by the first frequency divider or the second frequency divider.

Based on CLKGEN with the variable frequency division ratio, the clock signal frequency $f_{CLK\_PLL}$ of the common clock signal (PUB_CLK) output by the common phase-locked loop may be designed as a fixed frequency. This prevents a change in a frequency of a working clock of a module such as the ADC from affecting stable working of another module such as the DAC or the SerDes. The frequency of each module's working clock may be changed by adjusting the frequency division ratio of the corresponding clock frequency divider in the clock generator CLKGEN.

With the clock frequency divider, frequency division can be performed on the common clock signal (CLK_PUB) generated by the common phase-locked loop by using different frequency division ratios to obtain the frequency-divided signals to be provided to the DAC, the ADC, the SerDes, and the digital sub-system. In this way, the DAC, the ADC, the SerDes, and the digital sub-system can have different clock frequencies. The plurality of frequency dividers reduce requirements of the DAC, the ADC, the SerDes, and the digital sub-system in the system on the common clock signal and mutual dependence among these modules to further improve flexibility of system design.

The common phase-locked loop (PUB_PLL) may be an analog phase-locked loop or a digital phase-locked loop. In different implementations of the phase-locked loop, a covered frequency range and a frequency switching speed may be limited. To further improve performance and flexibility of the clock phase-locked loop and increase the frequency switching speed, the common phase-locked loop (CLK_PLL) may include two sub phase-locked loops: a first sub phase-locked loop (Sub _PLL2) and a second sub phase-locked loop (Sub _PLL2). A phase-locked loop selector (PLL_SEL) may be used to select Sub_PLL1 or Sub_PLL2 to be gated. The phase-locked loop controller may choose to output a clock signal of Sub _PLL 1 or Sub_PLL2 as the common clock signal for input to CLKGEN. The phase-locked loop selector may be a many-to-one switch, a plurality of parallel one-to-one switches, or a many-to-many switch. The phase-locked loop selector may be located at input or output ends of the two sub phase-locked loops. The phase-locked loop selector may alternatively be a power module, which implements a selection function by controlling power supply to the two sub phase-locked loops.

Frequency ranges covered by the two sub phase-locked loops may be the same, and a speed for fast frequency switching of the common phase-locked loop is increased through the selection by the phase-locked loop selector. Alternatively, the frequency ranges covered by the architectures of the two sub phase-locked loops may be different, and the frequency range covered by the common phase-locked loop is expanded through the selection by the phase-locked loop selector.

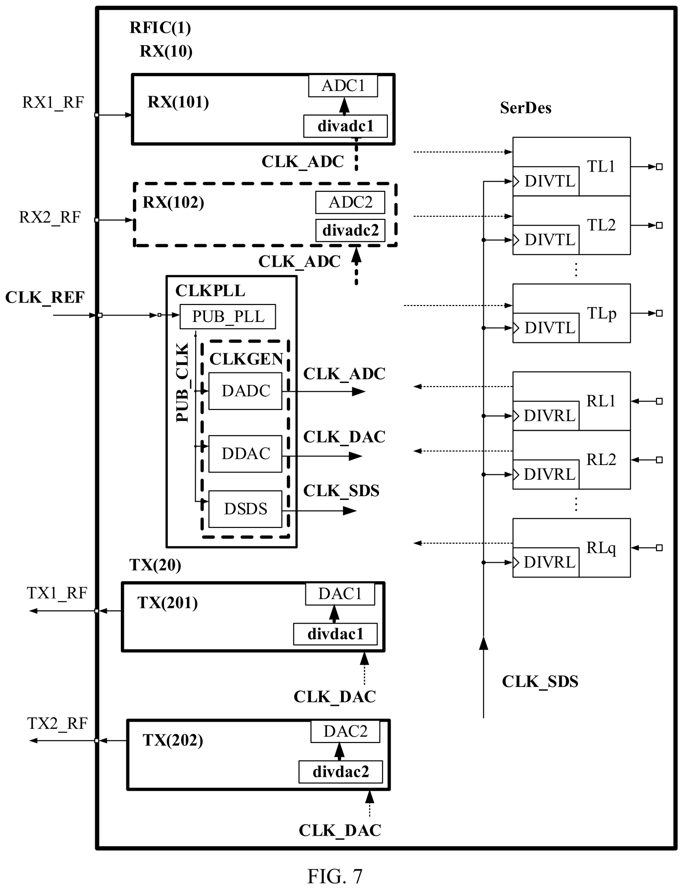

FIG. 7 is a schematic diagram of another wireless transceiver apparatus according to an embodiment of this application. On the basis of the foregoing embodiments, the radio frequency transmit paths, the radio frequency receive paths, the SerDes TLs, and the SerDes RLs each may include a corresponding local frequency divider.

CLK_ADC is a clock signal output by the common clock phase-locked loop to the ADC. The local frequency divider on the radio frequency receive path performs frequency division on CLK_ADC to obtain a clock signal needed by the ADC. Although FIG. 7 shows only two radio frequency receive paths and two radio frequency transmit paths, the wireless communications device in the embodiments of this application are not limited thereto. The wireless communications device may include other quantities of radio frequency receive paths and radio frequency transmit paths.

For example, there are two radio frequency receive paths. Assuming that a frequency of the clock signal needed by the ADC is $f_{ADC\_CLKPLL}$, and frequencies of clock signals needed by ADC1 on a first radio frequency receive path (RX(101)) and ADC2 on a second radio frequency receive path (RX(102)) are $f_{ADC1\_CLK}$ and $f_{ADC2\_CLK}$, the following relationships exist:

$$f_{ADC1\_CLK} = \frac{f_{ADC\_CLKPLL}}{N_{DIVADC1}}$$

$$f_{ADC2\_CLK} = \frac{f_{ADC\_CLKPLL}}{N_{DIVADC2}}$$

$N_{DIVADC1}$ and $N_{DIVADC}$, represent clock frequency division ratios of local analog to digital dividers divadc1 and divadc2 on the radio frequency receive paths.

After local analog to digital dividers are introduced to the plurality of radio frequency receive paths, each radio frequency receive path can be provided with a respective required clock signal, so that the radio frequency receive paths can work in different bandwidth modes. This increases flexibility of receiving a plurality of signals by the radio frequency receiver. For example, a first local analog to digital divider (divadcl) is introduced to a first radio frequency receive path (RX101) to perform frequency division on the input clock signal (CLK_ADC) to obtain a frequency-divided signal for provision to a first analog to digital converter (ADC1). A second local analog to digital divider (divadc2) is introduced to a second radio frequency receive path (RX102) to perform frequency division on the input clock signal (CLK_ADC) to obtain a frequency-divided signal for provision the first analog to digital converter (ADC2).

CLK_DAC is a clock signal output by the common clock phase-locked loop to the DAC. A local digital to analog divider (DAC DIV) on the radio frequency transmit path performs frequency division on CLK_DAC to obtain a frequency-divided signal for input to the DAC on the corresponding radio frequency transmit path. For example, there are two radio frequency transmit paths. Assuming that a frequency of the clock signal output by the common clock phase-locked loop to the DAC is $f_{DAC\_CLKPLL}$, and frequencies of clock signals needed by DAC1 on a first radio frequency transmit path (TX(201)) and DAC2 on a second radio frequency transmit path (TX(202)) are $f_{DAC1\_CLK}$ and $f_{DAC2\_CLK}$, the following relationships exist:

$$f_{DAC1\_CLK} = \frac{f_{ADC\_CLKPLL}}{N_{DIVDAC1}}$$

$$f_{DAC2\_CLK} = \frac{f_{ADC\_CLKPLL}}{N_{DIVDAC2}}$$

$N_{DIVDAC1}$ and $N_{DIVDAC2}$ represent clock frequency division ratios of local digital to analog dividers divdac1 and divdac2 on the radio frequency transmit paths. Similar to the radio frequency receive paths, after the local digital to analog dividers are introduced to the plurality of radio frequency transmit paths, the DAC on each radio frequency transmit path can be provided with a respective required clock signal, so that the radio frequency transmit paths can work in different bandwidth modes. This increases flexibility of transmitting a plurality of signals.

CLK_SDS is a clock signal output by the common clock phase-locked loop to the SerDes. The SerDes transmit lanes (TLs) and receive lanes (RLs) may work at different serial data rates, that is, may need clock signals of different frequencies. Therefore, the TLs and RLs each is integrated with a local frequency divider. The local frequency divider performs frequency division on CLK_SDS to obtain a clock signal needed by each lane. Assuming that a clock signal frequency of CLK_SDS is $f_{SDS\_CLKPLL}$, frequencies of clock signals needed by lanes TL1, TL2, ..., and TLp are $f_{TL1\_CLK}$, $f_{TL2\_CLK}$, ..., and $f_{TLp\_CLK}$, and frequencies of clock signals needed by lanes RL1, RL2, ..., and RLq are $f_{RL1\_CLK}$, $f_{RL2\_CLK}$, ...., and $f_{RLq\_CLK}$, the following relationships exist:

$$f_{TL1\_CLK} = \frac{f_{SDS\_CLKPLL}}{N_{DIVTL1}}$$

$$f_{TL2\_CLK} = \frac{f_{SDS\_CLKPLL}}{N_{DIVTL2}}$$

$$...$$

$$f_{TLp\_CLK} = \frac{f_{SDS\_CLKPLL}}{N_{DIVTLp}}$$

$$f_{RL1\_CLK} = \frac{f_{SDS\_CLKPLL}}{N_{DIVRL1}}$$

$$f_{RL2\_CLK} = \frac{f_{SDS\_CLKPLL}}{N_{DIVRL2}}$$

$$...$$

$$f_{RLq\_CLK} = \frac{f_{SDS\_CLKPLL}}{N_{DIVRLq}}$$

$N_{DIVTL1}$, $N_{DIVTL2}$, ..., and $N_{DIVTLp}$ represent clock frequency division ratios of clock frequency dividers DIVTL on the SerDes transmit lanes TL1, TL2, ..., and TLp, and $N_{DIVRL1}$, $N_{DIVTR2}$, ..., and $N_{DIVRLp}$ represent clock frequency division ratios of clock frequency dividers DIVRL on the SerDes receive lanes RL1, RL2, ..., and RLq. The introduction of the local frequency dividers increases flexibility of the clock signals needed by the transmit lanes and the receive lanes, so that the lanes can work in different bandwidth modes.

Further, the frequency division ratios of the local frequency dividers on the radio frequency receive and transmit paths and in the SerDes transmit and receive lanes are often designed to be variable based on respective clock frequency requirements of the ADC, the DAC, the SerDes, and the like. This prevents a change in a frequency of a working clock of a path or lane from affecting stable working of another path or lane. The frequency of each path or lane's working clock may be changed by adjusting the frequency division ratio of the corresponding local clock frequency divider. With the introduction of the local frequency dividers, the radio frequency receive and transmit paths and the corresponding serializer/deserializer (SerDes) transmit and receive lanes can work in different bandwidth modes.

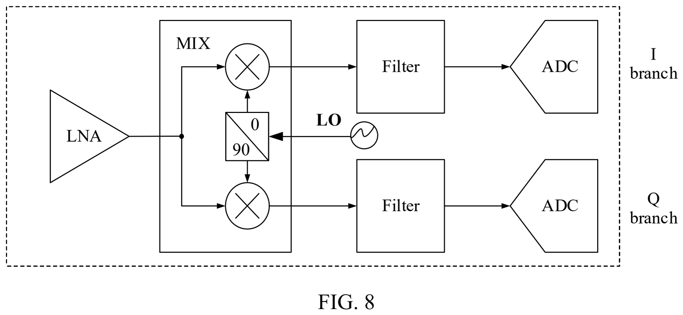

FIG. 8 is a schematic diagram of an architecture of a receiver according to an embodiment of this application. The receiver may be referred to as a zero intermediate frequency quadrature receiver (zero intermediate frequency quadrature receiver). The receiver may be applied to radio frequency receive paths in the embodiments of the present invention. The zero intermediate frequency quadrature receiver amplifies a received radio frequency signal through a low noise amplifier (LNA), and then mixes an amplified signal separately with two mutually orthogonal local oscillator signals through two mixers (MIX) to generate I (in-phase) and Q (quadrature) signals. Because the local oscillator signal has a same frequency as the radio frequency signal, an analog baseband signal is directly generated after the mixing. Then, a filter (filter) filters the analog baseband signal to suppress out-of-band interference or noise, thereby improving signal quality, reducing deterioration of sampling aliasing of an analog to digital converter (ADC), and increasing a signal-to-noise ratio. In addition, the filter usually can provide a specific adjustable gain to adjust an amplitude of the analog baseband signal to obtain desired signal strength at an input end of the ADC. The ADC performs analog to digital conversion on a signal obtained after processing by the filter into a digital baseband signal and transmits the digital baseband signal to a baseband processor for processing. In the baseband processor, operations such as demodulation and decoding are performed on the digital baseband signal to obtain data carrying useful information. Although the receiver in FIG. 4 has two branches, namely, I and Q branches, based on an orthogonal architecture, the receiver may further include differential links. To be specific, the I and Q branches each include a differential link.

In addition to the foregoing zero intermediate frequency quadrature receiver, a superheterodyne receiver is also a typical receiver. The superheterodyne receiver is similar to the zero intermediate frequency quadrature receiver. Differences lie in that a local oscillator frequency is different from an RF frequency; usually, a baseband signal can be generated through down conversion only after second mixing; and the baseband signal further needs to be processed by an image rejection filter before being processed by the ADC.

The radio frequency transmit path has an architecture similar to that of the radio frequency receive path. In a transmitting direction, the baseband processor first encodes and modulates data carrying useful information, preprocesses modulated data, and then transmits preprocessed data to the DAC. The DAC converts the transmitted digital baseband signal into an analog baseband signal and outputs the analog baseband signal to an RFIC. After receiving the analog baseband signal, the RFIC filters out an image signal brought in by the digital-to-analog conversion and suppresses quantization noise brought in by the digital baseband signal and the DAC through a filter. A filtered analog baseband signal is transferred to a radio frequency band through a radio frequency modulator and is output at specific power after power adjustment.

Although this embodiment describes the zero intermediate frequency quadrature or superheterodyne receiver, the RFIC of the wireless transceiver apparatus used to implement the functions of the present invention may alternatively be based on a receiver or transmitter in another form.

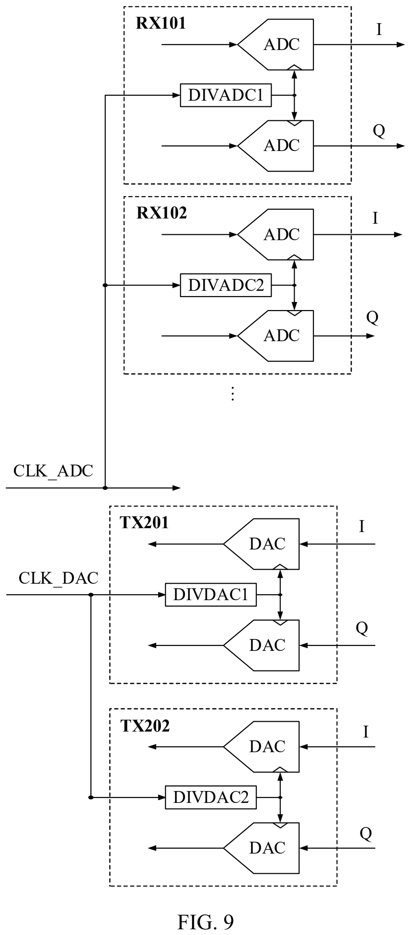

FIG. 9 is a schematic diagram of a local frequency divider based on an orthogonal architecture according to an embodiment of this application. On the basis of the foregoing embodiments, when the radio frequency receive path or transmit path has an orthogonal architecture with I and Q branches, because the I and Q branches have a same signal bandwidth, the ADCs or the DACs on the I and Q branches have a same bandwidth. One radio frequency receive path or transmit path needs only one local frequency divider to provide a clock signal for both ADCs or DACs on the I and Q branches of the radio frequency receive path or transmit path. This further saves frequency divider resources, and ensures that the ADCs or DACs on the I and Q branches have a same clock signal and that the I and Q signals have a same bandwidth. For example, a first radio frequency receive path (RX101) has an orthogonal architecture including two ADCs on I and Q branches. The first radio frequency receive path needs only one local frequency divider (DIVADC1) to provide a same clock reference signal for the two ADCs. Although FIG. 8 shows only two radio frequency receive paths and two radio frequency transmit paths, the wireless communications device in the embodiments of this application are not limited thereto. The wireless communications device may include three or more radio frequency receive paths and three or more radio frequency transmit paths.

On the basis of the foregoing embodiments, in consideration of implementation cost factors such as circuit implementation complexity, power consumption, and an area, the frequency division ratios of the clock frequency dividers in the clock generator CLKGEN and the local frequency dividers on the radio frequency receive paths or transmit path and the SerDes receive lanes or transmit lanes each may usually be designed as a positive integer or a combination of a positive integer and a simple decimal.

For example, a frequency division ratio of a frequency divider may be denoted as $N_{DCLK}$.

$$N_{DCLK} = N_{intg} + N_{frac}$$

$N_{intg}$ is a positive integer, namely:

$$N_{intg} = \{1, 2, 3, \ldots \ldots\}$$

When $N_{frac}$ is defined as a negative integer power of 2, namely, $N_{frac} = 2^F$, where $F = \{-1, -2, -3, \ldots\}$, $N_{frac}$ is a simple decimal. $N_{frac}$ may alternatively be 0.

The frequency division ratios of the clock frequency dividers DADC, DDAC, DDIG, and DSDS in the clock generator CLKGEN, DIVADC on each radio frequency receive path or DIVDAC on each radio frequency transmit path, and DIVTL in each SerDes transmit lane or DIVRL in each SerDes receive lane described in the foregoing embodiments each may have a relationship described in the foregoing formula. The frequency division ratios of the frequency dividers may be different, and appropriate frequency division ratios need to be selected based on clock frequency requirements of the ADC, the DAC, the SerDes, and the like.

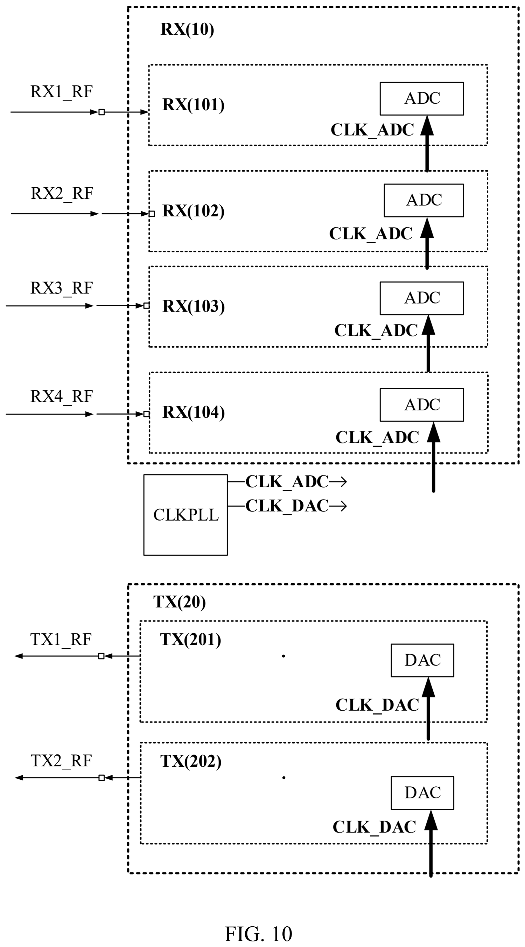

FIG. 10 is a schematic diagram of a radio frequency receiver and a radio frequency transmitter according to an embodiment of this application. Although FIG. 10 shows only four radio frequency receive paths and two radio frequency transmit paths, the radio frequency chip in the embodiments of this application are not limited thereto. The radio frequency chip may include more radio frequency receive paths and three or more radio frequency transmit paths.

After a local analog to digital divider and a local digital to analog divider are introduced, a bandwidth of each radio frequency receive path and a bandwidth of the processed signal of the radio frequency transmit path can be adjusted flexibly. Based on such a clock network architecture, the radio frequency transmit path and the radio frequency receive path of the radio frequency chip have a capability of simultaneously processing carrier aggregation and MIMO when reusing the clock frequency divider, and bandwidths of component carriers of paths may be different. In this way, competitiveness of the radio frequency chip is greatly improved, and a same radio frequency chip can support carrier aggregation and MIMO of different modes.

The radio frequency receiver may include a first radio frequency receive path (RX(101)), a second radio frequency receive path (RX(102)), a third radio frequency receive path (RX(103)), and a fourth radio frequency receive path (RX(104)). The first radio frequency receive path is configured to implement receiving processing on a first radio frequency signal, the second radio frequency receive path is configured to implement receiving processing on a second radio frequency signal, the third radio frequency receive path is configured to implement receiving processing on a third radio frequency signal, and the fourth radio frequency receive path is configured to implement receiving processing on a fourth radio frequency signal. The radio frequency transmitter may further include a first radio frequency transmit path (TX(201)) and a second radio frequency transmit path (TX(202)). The first radio frequency transmit path is configured to transmit a fifth radio frequency signal, and the second radio frequency transmit path is configured to transmit a sixth radio frequency signal. The common clock phase-locked loop is configured to provide a corresponding clock signal for an ADC and a DAC in each receive path and each transmit path.

Further, the radio frequency chip can implement transmitting and receiving in DLCA (four CCs) and ULCA (two CCs). A first radio frequency signal is CC1, a second radio frequency signal is CC2, a third radio frequency signal is CC3, a fourth radio frequency signal is CC4, a fifth radio frequency signal is CC5, and a sixth radio frequency signal is CC6. The carrier aggregation may be contiguous carrier aggregation or non-contiguous carrier aggregation, which may be intra-band non-contiguous carrier aggregation in a separate frequency band or inter-band non-contiguous carrier aggregation in different frequency bands. Because CC1 and CC4 are transmitted on different receive paths, from a perspective of system optimization, CC1 to CC4 may be intra-band non-contiguous downlink carrier aggregation or inter-band downlink carrier aggregation (DLCA). For example, CC1 and CC2 may be two non-contiguous carriers in a frequency band A, CC3 may be a carrier in a frequency band B, and CC4 may be a carrier in a frequency band C. For example, alternatively, CC1 and CC2 may be two non-contiguous carriers in the frequency band A, and CC3 and CC4 may be two non-contiguous carriers in the frequency band B.

Further, because CC5 and CC6 are transmitted on different transmit paths, CC5 and CC6 may be intra-band non-contiguous uplink carrier aggregation or inter-band uplink carrier aggregation (ULCA). For example, CC5 and CC6 may be two non-contiguous carriers in the frequency band A. CC5 and CC6 may alternatively be two carriers in the frequency bands A and B.

Further, the radio frequency chip can implement transmitting and receiving in DLCA (five CCs) and ULCA (two CCs). A first radio frequency signal is CC1, a second radio frequency signal is CC2, a third radio frequency signal is CC3, and a fourth radio frequency signal is CC4+CC5. CC1, CC2, and CC3 are inter-band downlink carrier aggregation (inter-band DLCA). CC4 and CC5 are intra-band downlink carrier aggregation (intra band DLCA). The radio frequency chip can implement receiving in DLCA of five CCs. In addition, a fifth radio frequency signal is CC5, and a sixth radio frequency signal is CC6. The radio frequency signals implement transmitting in ULCA of two CCs.

Further, the RFIC may further include a fifth radio frequency receive path, a sixth radio frequency receive path, and a seventh radio frequency receive path. The fifth radio frequency receive path is configured to implement receiving processing on a seventh carrier, the sixth radio frequency receive path is configured to implement receiving processing on an eighth carrier signal, and the seventh radio frequency receive path is configured to implement receiving processing on a ninth carrier signal. The seventh carrier signal, the eighth carrier signal, and the ninth carrier signal have same frequency band characteristics as a first carrier signal. In addition, the seventh carrier signal, the eighth carrier signal, and the ninth carrier signal are received from an antenna different from that for the first radio frequency signal. The common clock phase-locked loop is configured to provide clock signals for analog to digital converters corresponding to the fifth radio frequency receive path, the sixth radio frequency receive path, and the seventh radio frequency receive path, so that a seventh radio frequency signal, an eighth radio frequency signal, a ninth radio frequency signal, and the first radio frequency signal form receiving of a 4x4 MIMO signal. The RFIC can support CA and MIMO features.

Although this embodiment describes a scenario with only the foregoing two groups of carrier aggregation for transmitting and receiving and one group of MIMO, the wireless communications device in the embodiments of this application is not limited thereto, and the wireless communications device may include a configuration of another combination of carrier aggregation for transmitting and receiving and MIMO.

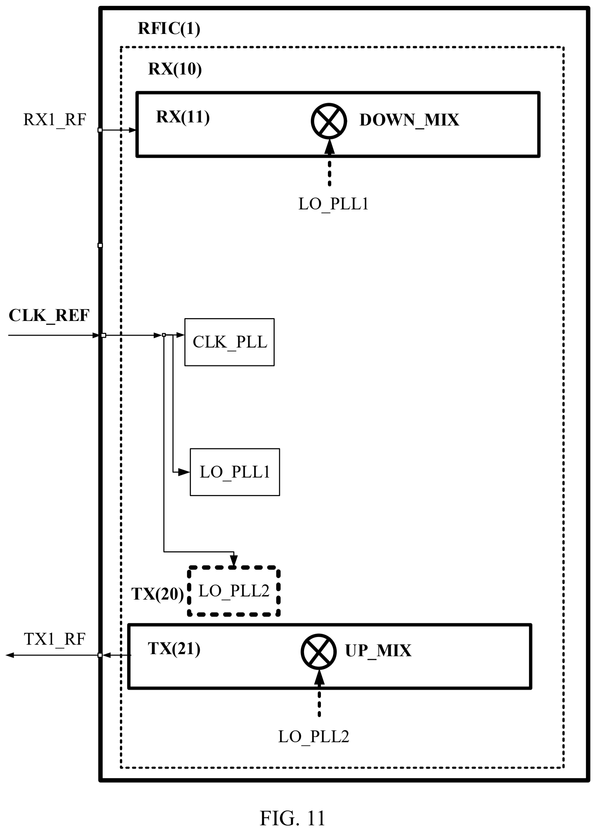

FIG. 11 is a schematic diagram of a radio frequency chip according to an embodiment of this application. On the basis of the foregoing embodiments, the radio frequency chip further includes a first local oscillator phase-locked loop (LO_PLL1), configured to provide a local oscillator signal for the radio frequency receiver or transmitter. Preferably, the first local oscillator phase-locked loop (LO_PLL1) is configured to provide a local oscillator signal for a mixer on a radio frequency transmit or receive path that supports the CA and MIMO features.

The local oscillator signal of the radio frequency transmitter or receiver, for example, a local oscillator signal needed by a radio frequency transmit or receive path that supports LTE and NR features, usually needs to meet specific requirements of the radio frequency transmit or receive path. For example, when a transmit or receive path needs to support a CA scenario specified in a protocol, especially intra-band CA, the path needs to cover a bandwidth of tens of megabits or even hundreds of megabits, and a bandwidth requirement of the path for a phase-locked loop is very strict. In addition, the radio frequency transmit or receive path needs to be capable of being switched at any time based on a scenario, and the local oscillation signal needs a fast switching capability. Therefore, in consideration of a great difference in requirements and performance between the common clock phase-locked loop providing the clock signals for the ADC, the DAC, and the SerDes and the phase-locked loop providing local oscillator signals for radio frequency transmit and receive paths, using the first local oscillator phase-locked loop to separately provide the local oscillator signals for the radio frequency transmit and receive paths improves efficiency and performance of clock signal design of the system from a perspective of system design.

The first local oscillator phase-locked loop may provide local oscillator signals for both a down converter Down_MIX on the first radio frequency receive path and an up converter UP_MIX on the first radio frequency transmit path.

Further, the radio frequency chip may further include a second local oscillator phase-locked loop (LO_PLL2). The first local oscillator phase-locked loop provides a local oscillator signal for a mixer mix on the receive path, and the second local oscillator phase-locked loop provides a local oscillation signal for a mixer mix on the transmit path. Different requirements of the transmit and receive paths for the phase-locked loops are met, and performance of the radio frequency chip is further optimized.

Furthermore, reference signals of the common clock phase-locked loop, the first local oscillator phase-locked loop, and the second local oscillator phase-locked loop may be provided by the same reference clock signal CLK_REF. The reference signal CLK_REF may be input from the outside of the RF chip through a same pin of the radio frequency chip. Therefore, an internal control timing of the chip can be synchronized with received and transmitted signals.

Although this embodiment describes only one radio frequency receive path, one radio frequency transmit path, and three phase-locked loops, the radio frequency chip in the embodiments of this application is not limited thereto. The radio frequency chip may include other quantities of radio frequency receive paths and radio frequency transmit paths and phase-locked loops providing another type of local oscillator signal.

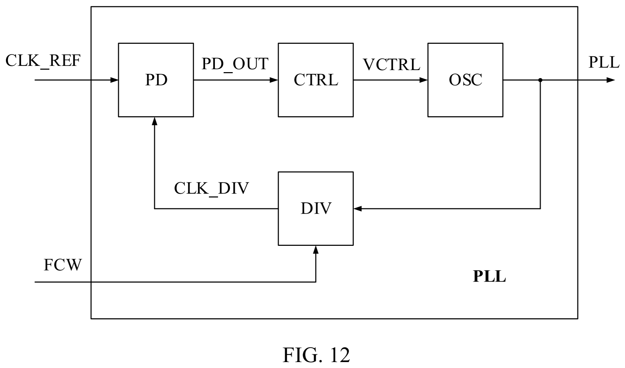

FIG. 12 is a schematic diagram of a phase-locked loop according to an embodiment of this application. In the foregoing embodiments, the first sub phase-locked loop, the second sub phase-locked loop, the first local oscillator phase-locked loop, and the second local oscillator phase-locked loop may be digital phase-locked loops or analog phase-locked loops. In this embodiment, a typical phase-locked loop circuit structure may be used by all of the first sub phase-locked loop, the second sub phase-locked loop, the first local oscillator phase-locked loop, and the second local oscillator phase-locked loop in the present invention. The phase-locked loop includes an oscillator OSC, configured to generate a clock signal of a specific frequency; a feedback frequency divider DIV, configured to perform frequency division processing on the signal output by the OSC to generate a feedback signal CLK_DIV whose frequency is close to the input reference clock CLK_REF; a phase detector PD, configured to obtain a phase difference through comparison between the feedback signal CLK_DIV and reference clock CLK_REF, and output an output signal PD_OUT related to the phase difference between the two signals; and a controller CTRL, configured to process the output signal PD_OUT output by the phase detector and generate a control signal VCTRL of the oscillator.

It can be learned from the foregoing key descriptions of each phase-locked loop that the phase-locked loop is a negative feedback system, and frequency and phase synchronization between the output signal CLK_PLL and the input reference clock signal is implemented by using a negative feedback mechanism. Under the negative feedback mechanism, a frequency $f_{CLK\_PLL}$ of the output signal CLK_PLL of the clock phase-locked loop may be as follows:

$$f_{CLK\_PLL} = N_{FCW} \cdot f_{CLK\_REF}$$

$N_{FCW}$ represents a frequency division ratio control word, used to control a frequency division ratio of the feedback frequency divider. Further embodiments of the present invention are provided in the following. It should be noted that the numbering used in the following section does not necessarily need to comply with the numbering used in the previous sections.

Embodiment 1. A wireless transceiver apparatus, comprising: a radio frequency receiver, a radio frequency transmitter, a first serializer/deserializer, and a common clock phase-locked loop, wherein the radio frequency receiver, the radio frequency transmitter, the first serializer/deserializer, and the common clock phase-locked loop are integrated in a radio frequency chip, the radio frequency receiver comprises a down converter and an analog to digital converter, the radio frequency transmitter comprises an up converter and a digital to analog converter, and the first serializer/deserializer is configured to provide a digital interface with a baseband chip for the radio frequency chip; and the common clock phase-locked loop is separately coupled to, the analog to digital converter, the digital to analog converter, and the first serializer/deserializer.

Embodiment 2. The wireless transceiver apparatus according to embodiment 1, further comprising:a baseband chip, wherein the baseband chip comprises a second serializer/deserializer, and the second serializer/deserializer is configured to provide a digital interface with the radio frequency chip for the baseband chip.

Embodiment 3. The wireless transceiver apparatus according to embodiment 1 or 2, wherein the common clock phase-locked loop comprises a common phase-locked loop and a clock generator; the common clock phase-locked loop is configured to generate a common clock signal; and the clock generator is configured to convert the common clock signal into a plurality of parallel clock signals and output the plurality of parallel clock signals to the analog to digital converter, the digital to analog converter, and the first serializer/deserializer.

Embodiment 4. The wireless transceiver apparatus according to embodiment 3, wherein the common phase-locked loop comprises a first sub phase-locked loop, a second sub phase-locked loop, and a phase-locked loop selector; and the phase-locked loop selector is configured to select the first sub phase-locked loop or the second sub phase-locked loop to generate the common clock signal.

Embodiment 5. The wireless transceiver apparatus according to embodiment 3 or 4, wherein the clock generator comprises a clock frequency divider, and the clock frequency divider is configured to perform frequency division on the common clock signal to generate a frequency-divided clock signal, and output the frequency-divided clock signal to the analog to digital converter, the digital to analog converter, or the first serializer/deserializer.

Embodiment. The wireless transceiver apparatus according to embodiment 5, wherein the clock frequency divider comprises a first frequency divider, a second frequency divider, and a frequency divider selector; and frequency division ratios of the first frequency divider and the second frequency divider are different, and the frequency divider selector is configured to select the first frequency divider or the second frequency divider to perform frequency division on the common clock signal.

Embodiment 7. The wireless transceiver apparatus according to any one of embodiments 1 to 6, wherein the radio frequency receiver comprises a plurality of radio frequency receive paths, and the radio frequency transmitter comprises a plurality of radio frequency transmit paths; and each of the radio frequency receive paths comprises one analog to digital converter, and each of the radio frequency transmit paths comprises one digital to analog converter.

Embodiment 8. The wireless transceiver apparatus according to embodiment 7, wherein each of the radio frequency receive paths further comprises a local analog to digital divider, and the local analog to digital divider on the radio frequency receive path performs frequency division on the signal output by the common clock phase-locked loop to obtain a frequency-divided signal for provision to the analog to digital converter on the radio frequency receive path.

Embodiment 9. The wireless transceiver apparatus according to embodiment 7 or 8, wherein each of the radio frequency transmit paths further comprises a local digital to analog divider, and the local digital to analog divider on the radio frequency transmit path performs frequency division on the signal output by the common clock phase-locked loop to obtain a frequency-divided signal for provision to the digital to analog converter on the radio frequency transmit path.

Embodiment 10. The wireless transceiver apparatus according to embodiment 8 or 9, wherein the plurality of radio frequency receive paths comprise a first radio frequency receive path, a second radio frequency receive path, a third radio frequency receive path, and a fourth radio frequency receive path, the first radio frequency receive path is configured to receive a first carrier signal, the second radio frequency receive path is configured to receive a second carrier signal, the third radio frequency receive path is configured to receive a third carrier signal, and the fourth radio frequency receive path is configured to receive a fourth carrier signal; the plurality of radio frequency transmit paths comprise a first radio frequency transmit path and a second radio frequency transmit path, the first radio frequency transmit path is configured to transmit a fifth carrier signal, and the second radio frequency transmit path is configured to transmit a sixth carrier signal; the first carrier signal, the second carrier signal, the third carrier signal, and the fourth carrier signal jointly form inter-band downlink carrier aggregation; and the fifth carrier signal and the sixth carrier signal jointly form intra-band non-contiguous uplink carrier aggregation or inter-band uplink carrier aggregation.

Embodiment 11. The wireless transceiver apparatus according to any one of embodiments 8 to 10, wherein each radio frequency receive path comprises an in-phase receive branch and a quadrature receive branch, and the in-phase receive branch and the quadrature receive branch each comprise one analog to digital converter; and the local analog to digital divider on the radio frequency receive path is configured to provide a same clock signal for an analog to digital converter in the in-phase receive branch and an analog to digital converter in the quadrature receive branch on the radio frequency receive path.

Embodiment 12. The wireless transceiver apparatus according to any one of embodiments 5 to 11, wherein frequency division ratios of the clock frequency divider are a positive integer or a sum of a positive integer and a simple decimal, wherein the simple decimal is a negative integer power of 2.

Embodiment 13. The wireless transceiver apparatus according to any one of embodiments 1 to 12, further comprising: a radio frequency front-end module, wherein the radio frequency front-end module comprises a low noise amplifier; the radio frequency front-end module is located between the radio frequency chip and an antenna; the radio frequency chip further comprises a p-channel metal oxide semiconductor PMOS transistor and an n-channel metal oxide semiconductor NMOS transistor, a source of the PMOS transistor is configured to be coupled to a power supply end, and a source of the NMOS transistor is configured to be coupled to a ground end; drains of the PMOS transistor and the NMOS transistor are coupled as an output end, which is configured to be coupled to a down converter; and gates of the PMOS transistor and the NMOS transistor are coupled as an input end, which is configured to be coupled to the low noise amplifier.

Embodiment 14. The wireless transceiver apparatus according to any one of embodiments 1 to 13, further comprising: a local oscillator phase-locked loop, configured to provide local oscillator signals needed for frequency conversion for the up converter and/or the down converter.

Embodiment 15. The wireless transceiver apparatus according to any one of embodiments 1 to 14, wherein the wireless transceiver apparatus further comprises a power supply chip, the power supply chip is coupled to the radio frequency chip, and the power supply chip supplies power to the radio frequency chip and provides a reference clock signal for the common clock phase-locked loop.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A wireless transceiver apparatus, comprising:

   a radio frequency receiver, comprises a down converter and an analog to digital converter;
   a radio frequency transmitter, comprises an up converter and a digital to analog converter;
   a first serializer/deserializer coupled to the radio frequency receiver and the radio frequency transmitter, and
   a common clock phase-locked loop coupled to the analog to digital converter, the digital to analog converter and the first serializer/deserializer respectively, wherein the common clock phase-locked loop comprises:

      a common phase-locked loop configured to output a common clock signal;
      a clock generator configured to generate, based on the common clock signal, a first clock signal, a second clock signal and a third clock signal respectively, and to provide the first clock signal to the ADC, the second clock signal to the DAC, and the third clock signal to the SerDes; and
      wherein at least one of the first clock signal, the second clock signal, or the third clock signal is generated by frequency-dividing the common clock signal using a variable frequency divider.

2. The wireless transceiver apparatus according to claim 1, further comprising:
   a baseband chip, wherein the baseband chip comprises a second serializer/deserializer, and the second serializer/deserializer is configured to provide a digital interface with the radio frequency chip for the baseband chip.

3. The wireless transceiver apparatus according to claim 1, wherein

   the common phase-locked loop comprises a first sub phase-locked loop, a second sub phase-locked loop, and a phase-locked loop selector; and
   the phase-locked loop selector is configured to select the first sub phase-locked loop or the second sub phase-locked loop to generate the common clock signal.

4. The wireless transceiver apparatus according to claim 1, wherein

the variable frequency divider comprises a first frequency divider, a second frequency divider, and a frequency divider selector; and frequency division ratios of the first frequency divider and the second frequency divider are different, and the frequency divider selector is configured to select the first frequency divider or the second frequency divider to perform frequency division on the common clock signal.

5. The wireless transceiver apparatus according to any one of claims 1 to 4, wherein

the radio frequency receiver comprises a plurality of radio frequency receive paths, and the radio frequency transmitter comprises a plurality of radio frequency transmit paths; and each of the radio frequency receive paths comprises one analog to digital converter, and each of the radio frequency transmit paths comprises one digital to analog converter.

6. The wireless transceiver apparatus according to claim 5, wherein each of the radio frequency receive paths further comprises a local analog to digital divider, and the local analog to digital divider on the radio frequency receive path performs frequency division on the signal output by the common clock phase-locked loop to obtain a frequency-divided signal for provision to the analog to digital converter on the radio frequency receive path.

7. The wireless transceiver apparatus according to claim 5 or 6, wherein each of the radio frequency transmit paths further comprises a local digital to analog divider, and the local digital to analog divider on the radio frequency transmit path performs frequency division on the signal output by the common clock phase-locked loop to obtain a frequency-divided signal for provision to the digital to analog converter on the radio frequency transmit path.

8. The wireless transceiver apparatus according to claim 6 or 7, wherein

the plurality of radio frequency receive paths comprise a first radio frequency receive path, a second radio frequency receive path, a third radio frequency receive path, and a fourth radio frequency receive path, the first radio frequency receive path is configured to receive a first carrier signal, the second radio frequency receive path is configured to receive a second carrier signal, the third radio frequency receive path is configured to receive a third carrier signal, and the fourth radio frequency receive path is configured to receive a fourth carrier signal; the plurality of radio frequency transmit paths comprise a first radio frequency transmit path and a second radio frequency transmit path, the first radio frequency transmit path is configured to transmit a fifth carrier signal, and the second radio frequency transmit path is configured to transmit a sixth carrier signal; the first carrier signal, the second carrier signal, the third carrier signal, and the fourth carrier signal jointly form inter-band downlink carrier aggregation; and the fifth carrier signal and the sixth carrier signal jointly form intra-band non-contiguous uplink carrier aggregation or inter-band uplink carrier aggregation.

9. The wireless transceiver apparatus according to any one of claims 6 to 8, wherein

each radio frequency receive path comprises an in-phase receive branch and a quadrature receive branch, and the in-phase receive branch and the quadrature receive branch each comprise one analog to digital converter; and the local analog to digital divider on the radio frequency receive path is configured to provide a same clock signal for an analog to digital converter in the in-phase receive branch and an analog to digital converter in the quadrature receive branch on the radio frequency receive path.

10. The wireless transceiver apparatus according to any one of claims 1 to 9, wherein frequency division ratios of the clock frequency divider are a positive integer or a sum of a positive integer and a simple decimal, wherein the simple decimal is a negative integer power of 2.

11. The wireless transceiver apparatus according to any one of claims 1 to 10, further comprising:

a radio frequency front-end module, wherein the radio frequency front-end module comprises a low noise amplifier; the radio frequency front-end module is located between the radio frequency chip and an antenna; the radio frequency chip further comprises a p-channel metal oxide semiconductor PMOS transistor and an n-channel metal oxide semiconductor NMOS transistor, a source of the PMOS transistor is configured to be coupled to a power supply end, and a source of the NMOS transistor is configured to be coupled to a ground end; drains of the PMOS transistor and the NMOS transistor are coupled as an output end, which is configured to be coupled to a down converter; and gates of the PMOS transistor and the NMOS transistor are coupled as an input end, which is configured to be coupled to the low noise amplifier.

12. The wireless transceiver apparatus according to any one of claims 1 to 11, further comprising:
a local oscillator phase-locked loop, configured to provide local oscillator signals needed for frequency conversion for the up converter and/or the down converter.

13. The wireless transceiver apparatus according to any one of claims 1 to 12, wherein
the wireless transceiver apparatus further comprises a power supply chip, the power supply chip is coupled to the radio frequency chip, and the power supply chip supplies power to the radio frequency chip and provides a reference clock signal for the common clock phase-locked loop.

UL

DL

Terminal

Base
station

FIG. 1

CC 1

CC 2

CC 3

CC 4

CC 5

CC 6

First
carrier set

Second
carrier set

FIG. 2

FIG. 3

FIG. 4

**SerDes**

FIG. 5A

FIG. 5B

CLKPLL

PUB_PLL

Sub_PLL2

Sub_PLL1

PLL_SEL

PUB_CLK

CLK_REF

CLKGEN

DADC — CLK_ADC

DDIG — CLK_DDIG

DDAC — CLK_DAC

DSDS — CLK_SDS

FIG. 6

FIG. 7

FIG. 8

FIG. 9

FIG. 10

RFIC(1)

RX(10)

RX(11)                    ⊗   DOWN_MIX

RX1_RF

                              LO_PLL1

CLK_REF

                    CLK_PLL

                    LO_PLL1

TX(20)   LO_PLL2

TX1_RF

TX(21)                    ⊗   UP_MIX

                              LO_PLL2

FIG. 11

FIG. 12